(19) Europäisches Patentamt
European Patent Office
Office européen des brevets

(11) **EP 2 071 342 B1**

(12) **EUROPÄISCHE PATENTSCHRIFT**

(45) Veröffentlichungstag und Bekanntmachung des Hinweises auf die Patenterteilung:
**25.11.2009 Patentblatt 2009/48**

(51) Int Cl.:
**G01R 31/14** (2006.01)

(21) Anmeldenummer: **07023864.7**

(22) Anmeldetag: **10.12.2007**

(54) **Vorrichtung und Verfahren zur Erzeugung eines definierten Ladungspulses zur Ausführung einer Teilentladungsmessung**

Device and method for creating a defined charge pulse for a partial discharge measurement

Dispositif et procédé de production d'une impulsion de charge définie pour l'exécution d'une mesure de décharge partiel

(84) Benannte Vertragsstaaten:
**AT BE BG CH CY CZ DE DK EE ES FI FR GB GR HU IE IS IT LI LT LU LV MC MT NL PL PT RO SE SI SK TR**

(43) Veröffentlichungstag der Anmeldung:
**17.06.2009 Patentblatt 2009/25**

(73) Patentinhaber: **mtronix Precision Measuring Instruments GmbH**
**10557 Berlin (DE)**

(72) Erfinder:
• **Emanuel, Harald**
**10553 Berlin (DE)**

• **Boschet, Vincent**
**13187 Berlin (DE)**

(74) Vertreter: **Banzer, Hans-Jörg et al**
**Kraus & Weisert**
**Patent- und Rechtsanwälte**
**Thomas-Wimmer-Ring 15**
**80539 München (DE)**

(56) Entgegenhaltungen:
**DE-A- 3 912 654      US-A1- 2005 128 655**
**US-B1- 7 119 597**

**Beschreibung**

Die vorliegende Erfindung betrifft eine Vorrichtung zur Erzeugung eines definierten Ladungspulses zur Durchführung einer Teilentladungsmessung sowie ein entsprechendes Verfahren. Gemäß einer bevorzugten Ausführungsform betrifft die vorliegende Erfindung die Erzeugung von definierten Ladungspulsen zur Durchführung von Teilentladungsmessungen oder Isolationsprüfungen von elektrischen Komponenten, wie z.B. Kabeln, rotierenden Maschinen, Transformatoren oder dergleichen, wobei die Erfindung vorzugsweise, jedoch nicht ausschließlich auf die Durchführung von Hochspannungs-Teilentladungsmessungen anwendbar ist, um durch Teilentladungs- bzw. Isolationsprüfungen Isolationsfehler an Hochspannungskomponenten zu erkennen.

Teilentladungsphänomene deuten in vielen Fällen auf Isolationsfehler von elektrischen Komponenten, insbesondere von Hochspannungskomponenten hin. Die Überwachung, Erkennung, Lokalisierung, Aufzeichnung und Analyse von Teilentladungsphänomenen ist somit die Voraussetzung für einen zuverlässigen Schutz von später sehr kostenintensiven Ausfällen und Reparaturen. Es werden daher bereits hochpräzise und modulare Teilentladungs-Messsysteme zur Erkennung, Aufzeichnung und Analyse von Teilentladungsereignissen in einem breiten Spektrum von Anwendungen angeboten, wobei hiermit sowohl für Anwendungen im Labor als auch bei Vor-Ort-Messungen Teilentladungen überwacht und erfasst werden können. Dabei können alle Arten von elektrischen Komponenten, wie z.B. Transformatoren, rotierende Maschinen und Kabelnetze (einschließlich Hoch- und Höchstspannungskabel) analysiert werden.

Um die Durchführung von zuverlässigen Teilentladungsmessungen zu ermöglichen, werden Teilentladungskalibratoren verwendet, welche direkt mit dem Testobjekt gekoppelt werden und während eines Kalibriervorgangs kontinuierlich Ladungspulse erzeugen, so dass das jeweilige Teilentladungsmessgerät während der Dauer der Kalibrierung diese Impulse erfasst. Anhand der detektierten Impulse ist eine Funktionskontrolle des Messgerätes möglich. Wichtiger ist jedoch die Bestimmung des so genannten Kalibrierfaktors. Die vom Kalibrator erzeugten Impulse werden in Abhängigkeit vom Messaufbau (primär der Prüflingskapazität bzw. der Kapazität des Koppelkondensators, aber auch von physischer Ausdehnung sowie Messfrequenz) gedämpft. Der Kalibrierfaktor kompensiert diese Dämpfung; er muss bei jeder Änderung am Messaufbau neu bestimmt werden.

Zur Erzeugung der definierte Kalibrierladungspulse kann ein Rechteckspannungssprung und ein genauer Kondensator verwendet werden, wobei jedoch ein in den Kalibrator eingebauter Kondensator in der Regel lediglich Spannungen bis 500V aushält. Durch die Verwendung eines externen Hochspannungskondensators kann zwar eine Kalibrierung während einer Hochspannungsmessung durchgeführt werden, wobei jedoch derartige Hochspannungskondensatoren einerseits relativ teuer sind und andererseits die Baugröße des Kalibrators deutlich erhöhen. Zusätzlich wirken sich solche Injektionskondensatoren im Zusammenspiel mit Koppel- und Prüflingskapazität ungünstig auf die Empfindlichkeit des Teilentladungs-Messgerätes aus. Auch besteht das Risiko, dass der Injektionskondensator selber nicht teilentladungsfrei ist und so die Messung verfälscht.

Ein weiteres mit bekannten Kalibratoren verbundenes Problem besteht darin, dass aufgrund der bei hohen Spannungen durchzuführenden Messungen die Leitungen zwischen dem Messobjekt und dem Kalibrator entsprechend lang sein müssen, wobei jedoch der Kalibrierpuls durch die Induktivität der Leitung verändert wird und abhängig vom Messort und der Messfrequenz deutliche Fehler bei der Messung auftreten können.

Aus der DE 39 12 654 A1 ist eine Vorrichtung zur Erzeugung eines definierten Ladungspulses zur Durchführung einer Teilentladungsmessung nach dem Oberbegriff des Anspruches 1 bekannt. Zu diesem Zweck wird gemäß dieser Druckschrift ein Ladungsinjektor vorgeschlagen, welcher einen in einem Gehäuse befindlichen Ladespeicherkondensator umfasst, der von einer Ladeeinrichtung gespeist wird und mit einem Kurzzeitschalter in Reihe mit hochohmigen Widerständen parallelgeschaltet ist. An einem Verbindungspunkt zwischen einem der hochohmigen Widerstände und dem Kurzzeitschalter ist ein mit einem ersten Ausgangsanschluss des Ladungsinjektors gekoppelter Reihenkondensator angeschlossen, wobei ein zweiter Ausgangsanschluss des Ladungsinjektors mit dem anderen Anschluss des Kurzzeitschalters gekoppelt ist. Mit Hilfe des Kurzzeitschalters wird der Reihenkondensator kurzzeitig mit einem Bezugspotential verbunden, wobei anschließend die direkte Verbindung zwischen dem Reihenkondensator und dem Bezugspotential wieder aufgehoben wird. Zum Einkoppeln der somit gespeicherten Ladung kann entweder das Gehäuse des Ladungsinjektors oder eine mit dem ersten Ausgangsanschluss des Ladungsinjektors gekoppelte Antenne als Strahler verwendet werden. Der Ladungsinjektor dieser Druckschrift wird vorzugsweise zur Kalibrierung eines Teilentladungsnetzkreises verwendet, um Teilentladungen in Hochspannungseinrichtungen simulieren zu können.

Aus US 7,119,597 B1 und US 2005/0128655 A1 sind weitere Vorrichtungen bekannt, um durch kurzzeitige Aufladung eines Kondensators Strom- bzw. Spannungspulse zum Testen eines Prüflings zu erzeugen.

Der vorliegenden Erfindung liegt die Aufgabe zugrunde, eine Vorrichtung sowie ein Verfahren zur Erzeugung eines definierten Ladungspulses zur Durchführung einer Teilentladungsmessung an einer elektrischen Komponente bereitzustellen, womit die zuvor erwähnten Probleme beseitigt werden können. Insbesondere liegt der Erfindung die Aufgabe zugrunde, eine Vorrichtung sowie ein Verfahren zur Erzeugung von definierten Ladungspulsen zur Durchführung von Hochspannungs-Teilentladungsmessungen an Hochspannungskomponenten, wie z.B. Transformatoren, rotierenden Maschinen oder Kabeln, bereitzustellen, womit eine kostengünstige, zuverlässige und einfach handhabbare Kalibrierung bei der Durchführung der Hochspannungs-Teilentladungsmessungen möglich ist.

Diese Aufgabe wird erfindungsgemäß durch eine Vorrichtung mit den Merkmalen des Anspruches 1 bzw. ein Verfahren mit den Merkmalen des Anspruches 26 gelöst. Die abhängigen Ansprüche definieren jeweils bevorzugte und vorteilhafte Ausführungsformen der vorliegenden Erfindung.

Erfindungsgemäß wird eine Vorrichtung zur Erzeugung eines definierten Ladungspulses zur Durchführung von Teilentladungsmessungen an einer elektrischen Komponente bereitge-stellt, wobei die Vorrichtung ein Gehäuse, eine an dem Gehäuse anzubringende Außenelektrode und eine Steuereinheit umfasst. Die Steuereinheit ist derart ausgestaltet, dass sie abhängig von einer Streukapazität der Außenelektrode den definierten Ladungspuls erzeugt.

Die Außenelektrode ist außen an dem Gehäuse der erfindungsgemäßen Vorrichtung, welche nachfolgend auch als Kalibratorvorrichtung bzw. einfach als Kalibrator bezeichnet wird, anzubringen, wobei die Streukapazität zwischen der Außenelektrode und Erde definiert ist. Erfindungsgemäß wird diese Streukapazität anstelle eines diskreten Hochspannungskondensators zum Einspeisen der Kalibrier- bzw. Ladungspulse zur Durchführung der Teilentladungsmessungen verwendet. Daher sind keine zusätzlichen Anschlussdrähte erforderlich, um den Ausgangsanschluss mit dem Testobjekt zu verbinden. Stattdessen kann die erfindungsgemäße Vorrichtung unmittelbar und demzufolge weitgehend induktionsfrei an das Testobjekt angeschlossen werden, so dass sich die Streukapazität nahe an dem Testobjekt befindet und die durch die Anschlussleitungen hervorgerufenen parasitären Effekte vernachlässigbar sind. Demzufolge kann die Kalibrierung genauer und zuverlässiger durchgeführt werden, was auch eine verbesserte Qualität und Reproduzierbarkeit der entsprechenden Teilentladungsmessungen zur Folge hat.

Nachdem erfindungsgemäß anstelle eines externen Hochspannungskondensators eine Außenelektrode mit Streukapazität gegen Erde verwendet wird, können die Größe des Geräts und die zur Herstellung erforderlichen Kosten deutlich reduziert werden.

Gemäß einer bevorzugten Ausführungsform können von einem Benutzer Parameter für die durchzuführende Kalibrierung, wie beispielsweise das gewünschte Ladungsniveau der Ladungspulse, eingegeben werden, während das Gerät automatisch abhängig von diesen Parametern und der Streukapazität der Außenelektrode den von einer internen Spannungsquelle zu erzeugenden Spannungssprung berechnet, um über den Ausgang des Geräts die gewünschte Ladung an das Testobjekt abgeben zu können.

Die Streukapazität der Außenelektrode ist in der Regel unbekannt und von den Bedingungen am Einsatzort abhängig. Bei Verwendung unter freiem Himmel kann die Streukapazität unter bestimmten Umständen abgeschätzt werden, z.B. bei Verwendung einer Kugelelektrode bei Nichtvorhandensein von metallischen Gegenständen in der Nähe der Außenelektrode. Bei Kenntnis der Streukapazität kann das Gerät automatisch den für den gewünschten Ladungspuls erforderlichen internen Spannungsprung berechnen.

Ist jedoch die Streukapazität nicht bekannt und kann auch nicht abgeschätzt werden, wird gemäß einer bevorzugten Ausführungsform eine interne Selbstkalibrierung derart durchgeführt, dass zunächst durch eine Probemessung die Streukapazität am Einsatzort ermittelt wird, um anschließend mit Kenntnis dieser Streukapazität den für die Erzeugung des gewünschten Ladungspulses erforderlichen Spannungsprung berechnen zu können. Zu diesem Zweck kann die Außenelektrode bzw. die von der Außenelektrode gegen Erde gebildete Streukapazität mit einer internen Referenzkapazität derart verschaltet sein, dass die beiden Kapazitäten einen Spannungsteiler bilden, wobei zur Durchführung der Probemessung eine von der externen Prüfspannungsquelle erzeugte Hochspannung angelegt wird, welche das Teilentladungsmessgerät genau erfasst. Die interne Spannungsquelle im Kalibrator ist zu diesem Zeitpunkt deaktiviert.

Die an der internen Referenzkapazität abfallende Spannung wird automatisch ausgewertet, wobei die Streukapazität aufgrund der Kenntnis über die interne Referenzkapazität, die an der Referenzkapazität abfallende Spannung und die zur Durchführung der Probemessung angelegte Spannung bestimmt werden kann.

Der erfindungsgemäße Kalibrator kann sowohl zur Durchführung einer einzelnen Teilentladungsmessung als auch zu Überwachungszwecken dauerhaft an das Testobjekt angeschlossen werden und verfügt optional über Tasten zum Einstellen der zu erzeugenden Ladung sowie eine Anzeige zur Darstellung der Ladung. Darüber hinaus verwendet der Kalibrator gemäß einer bevorzugten Ausführungsform einen optischen Eingang zur Ansteuerung des Kalibrators, wobei der Kalibrator über diese optische Schnittstelle mit einem Teilentladungsmessgerät gekoppelt werden kann, um auf diese Weise über das Teilentladungsmessgerät den Kalibrator ein- und ausschalten zu können sowie wichtige Parameter des Kalibrators, wie beispielsweise Ladungsniveau, Ladungspolarität oder Pulswiederholrate, einstellen zu können. Darüber hinaus kann der Kalibrator über einen optischen Ausgang zur Messdatenübermittlung an das Teilentladungsmessgerät verfügen. Der Betrieb auf Potential erfordert eine elektrisch isolierte Schnittstelle zwischen Kalibrator und Steuergerät. Zusätzlich ergibt sich eine deutlich erhöhte Sicherheit und Messgenauigkeit bei Hochspannungs-Messaufgaben und die Entstehung von Erdschleifen wird verhindert, wodurch Störungseinflüsse verringert werden können und die Abtastempfindlichkeit verbessert werden kann.

Darüber hinaus können ohne Einbußen bei der Messgenauigkeit mehrere vollständig synchron arbeitende Teilentladungsmessgeräte über weite Distanzen voneinander getrennt aufgestellt werden, wobei die einzelnen angeschlossenen Messgeräte jeweils vollständig galvanisch voneinander getrennt sind. Die Steuerung der einzelnen Teilentladungsmessgeräte sowie des Kalibrators erfolgt ausgehend von einem zentralen Steuerplatz, vorzugsweise in Form eines zentralen Steuer-Personal Computer.

Gemäß einer bevorzugten Ausführungsform handelt es sich bei der erfindungsgemäßen Vorrichtung um ein batteriebetriebenes tragbares Gerät, welches in Übereinstimmung mit den gängigen Standards (bei Durchführung von Hochspannungs-Teilentladungsmessungen IEC 60270 und IEEE 454) ausgestaltet ist. Bei Verwendung einer optischen Schnittstelle zur Ansteuerung des Kalibrators muss lediglich der optische Empfänger des Kalibrators dauerhaft eingeschaltet sein, wobei ein derartiger optischer Empfänger einen äußerst geringen Stromverbrauch besitzt, so dass ein Batteriebetrieb von bis zu 10 Jahren oder mehr möglich ist. Die Lebensdauer der Batterie sollte dabei derart gewählt sein, dass die Batterie einem Mehrfachen der Zeitspanne entspricht, nach der gemäß den gängigen internationalen Standards eine Überprüfung der Leitungsfähigkeit des Kalibrators durchgeführt werden muss. Durch das Vorsehen eines Batteriebetriebs kann der Kalibrator ohne jegliches Sicherheitsrisiko auf Hochspannungspotential betrieben werden.

Gemäß einer Ausführungsform der Erfindung handelt es sich bei dem erfindungsgemäßen Kalibrator um einen potenzialfreien Online-Teilentladungskalibrator, welcher insbesondere zur Durchführung von Hochspannungs-Teilentladungsmessungen an elektrischen Komponenten, beispielsweise Kabeln, rotierenden Maschinen oder Transformatoren, im Labor oder vor Ort eingesetzt werden kann. Die Erfindung ist jedoch nicht auf diesen bevorzugten Anwendungsbereich beschränkt, sondern kann überall dort eingesetzt werden, wo zur Durchführung von Teilentladungsmessungen Kalibrierladungspulse erzeugt und an ein Testobjekt abgegeben werden sollen. So kann die Erfindung beispielsweise auch für Teilentladungs- oder Isolationsprüfungen an Optokopplern, Leistungshalbleitern, Kondensatoren, Widerständen, Drosselspulen, Relais oder dergleichen eingesetzt werden.

Der erfindungsgemäße Kalibrator kann mit einer Außenelektrode oder mit einem Satz von unterschiedlichen Außenelektroden ausgeliefert bzw. betrieben werden. Zur Erzeugung größerer Ladungen sollte die Streukapazität der Außenelektrode einen möglichst großen Radius haben, so dass gemäß einer Ausführungsform der Erfindung als Außenelektrode eine Kugelform, Halbkugelform, oder ein Toroid verwendet werden kann. Zur Erzeugung noch größerer Ladungen kann die Außenelektrode in die Nähe des Erdfelds gebracht werden. Die Außenelektrode sollte möglichst keine Spitzen oder Kanten aufweisen, da sonst Koronaentladungen auftreten können, welche die Genauigkeit bei der Erzeugung des Kalibrierpulses beeinflussen können. Nachdem sich bei relativ großen Außenelektroden externe Störungen oder Änderungen der externen Einflüsse stärker auswirken, ist es vorteilhaft, wenn für die Außenelektrode möglichst kleine Geometrien verwendet werden. Denkbar ist auch eine Integration der Außenelektrode in das Kalibratorgehäuse.

Mit einer Außenelektrode kann ein Dynamikbereich der erzeugbaren Ladungsmenge von 1:100 realisiert werden. Größere Ladungsmengen können durch Verwendung unterschiedlicher Außenelektroden erzeugt werden. Aus diesem Grund ist es vorteilhaft, wenn mit dem Kalibrator ein Satz von unterschiedlichen Außenelektroden mitgeliefert wird, welche jeweils für unterschiedliche Anwendungsfälle optimale Ergebnisse realisieren. Generell sollten die Außenelektroden jeweils teilentladungsfrei sein, wobei jedoch für die Kalibrierung von elektrischen Maschinen geringe Teilentladungen akzeptabel sind.

Der mit Hilfe der internen Spannungsquelle realisierte Spannungssprung zur Erzeugung des Kalibrierpulses sollte in der Praxis möglichst groß sein, um eine zuverlässige Kalibrierung der jeweiligen elektrischen Komponente zu ermöglichen. Hierzu kann gemäß einer Ausführungsform der Kalibrator beispielsweise eine interne 90V-Spannungsquelle aufweisen, welche von einer internen Steuereinheit, vorzugsweise in Form eines Microcontrollers, gesteuert wird. Um ausreichend Reserve zu haben, wird in der Regel mit einer derartigen 90V-Spannungsquelle zur Erzeugung der Kalibrierpulse ein maximaler Spannungsprung mit 80 V erzeugt.

Gemäß einer weiteren bevorzugten Ausführungsform der Erfindung kann der Kalibrator eine Fotodiode oder dergleichen aufweisen, mit deren Hilfe der Kalibrator zur netzsynchronen Kalibrierung durch Erfassung einer mit Netzspannung betriebene Lichtquelle synchronisiert werden kann. Ebenso können die einzelnen Teilentladungsmessgeräte, welche zusammen mit dem erfindungsgemäßen Kalibrator betrieben werden können jeweils eine derartige Fotodiode zur Synchronisierung einer mit Netzspannung betriebenen Lichtquelle aufweisen.

Um den Kalibrator weitgehend unabhängig von externen Einflüssen zu machen, kann der Kalibrator bzw. dessen Außenelektrode in einer externe Einflüsse abschirmenden Einrichtung angeordnet werden, welche im Inneren der Einrichtung ein vordefiniertes elektrisches Feld erzeugt. Gemäß einer Ausführungsform umfasst diese vordefinierte Struktur zwei Toroide, wobei sich ein Toroid auf Erdpotenzial und der andere Toroid auf einem hohen Potenzial befindet. Allgemein ist es vorteilhaft, wenn zur Reduzierung externer Einflüsse ein definierter Raum um den Kalibrator herum frei von irgendwelchen geerdeten oder auf einem höheren Potenzial liegenden Objekten gehalten wird.

Die Erfindung wird nachfolgend näher unter Bezugnahme auf die beigefügte Zeichnung anhand bevorzugter Ausführungsbeispiele erläutert. Dabei wird die Erfindung insbesondere anhand des Beispiels der Erzeugung von Kalibrierladungspulsen zur Durchführung von Hochspannnungs-Teilentladungsmessungen an elektrischen Komponenten, insbesondere an Hochspannungsbetriebsmitteln, beschrieben, wobei die Erfindung jedoch nicht auf diesen bevorzugten Anwendungsfall beschränkt ist, sondern überall dort Anwendung finden kann, wo definierte Ladungspulse zur Durchführung von Teilentladungsmessungen erzeugt werden sollen.

Fig. 1 zeigt ein vereinfachtes Blockschaltbild einer Vorrichtung zur Erzeugung definierter Ladungspulse zur Durchführung von Teilentladungsmessungen an elektrischen Komponenten gemäß einem bevorzugten Ausführungsbeispiel der Erfindung, und

Fig. 2 zeigt eine schematische Darstellung zur Verdeutlichung des Einsatzes der in Fig. 1 dargestellten Vorrichtung zusammen mit entsprechenden Teilentladungsmessgeräten zur Online-Kalibrierung während einer Teilentladungsmessung.

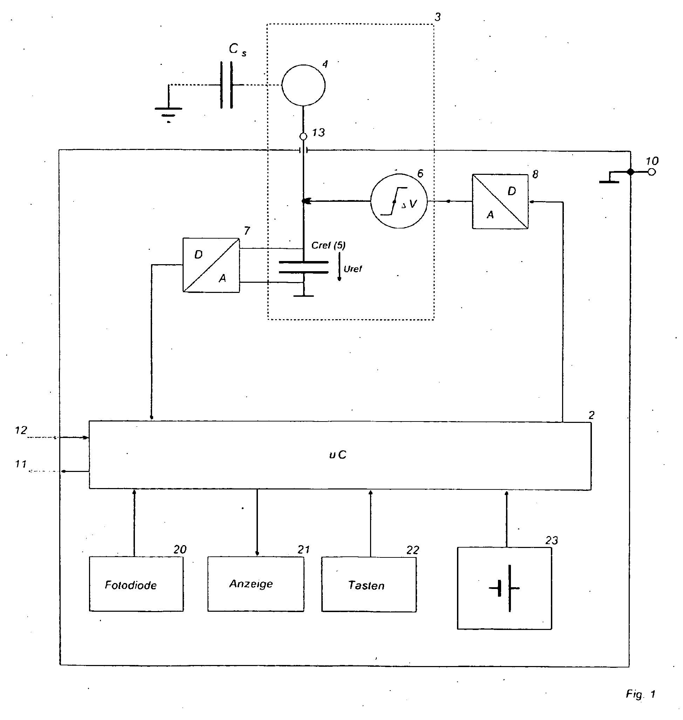

Fig. 1 zeigt ein vereinfachtes Blockschaltbild einer Kalibriervorrichtung bzw. eines Kalibrators zur Erzeugung vordefinierter Ladungspulse zur Durchführung von Teilentladungsmessungen an elektrischen Komponenten gemäß einem Ausführungsbeispiel der vorliegenden Erfindung, wobei es sich bei dem in Fig. 1 dargestellten Kalibrator insbesondere um einen Kalibrator zur Durchführung von Hochspannungs-Teilentladungsmessungen an Hochspannungsleitungen, Transformatoren oder dergleichen handelt.

Bei dem in Fig. 1 dargestellten Kalibrator handelt es sich um ein tragbares Gerät, welches direkt mit einem Testobjekt, verbunden werden kann. Zu diesem Zweck weist der Kalibrator einen Anschluss 10 auf, über welchen vordefinierte Kalibrierladungspulse an das Testobjekt abgegeben werden, wobei diese Kalibrierladungspulse insbesondere laufend während der Durchführung einer Hochspannungs-Teilentladungsmessung erzeugt werden, um auch bei sich verändernden Messbedingungen eine fortlaufende Kalibrierung und eine kontinuierliche Selbstüberprüfung des entsprechenden Teilentladungsmessgeräts zu ermöglichen.

Das Gehäuse 1 des Kalibrators umfasst einen weiteren Anschluss 13, an welchen eine Außenelektrode 4 anzuschließen ist. Bei dem in Fig. 1 dargestellten Beispiel besitzt die Außenelektrode 4 eine Kugelform, wobei auch andere Formen, wie beispielsweise eine Halbkugel oder ein Toroid möglich sind. Die Außenelektrode 4 definiert gegenüber Erde Streukapazitäten $C_s$, welche in Fig. 1 durch entsprechende Pfeile dargestellt sind. Diese Streukapazitäten $C_s$ der Außenelektrode 4 werden von dem Kalibrator zur Erzeugung der über den Anschluss 10 an das Testobjekt abzugebenden Kalibrierladungspulse verwendet, wie dies nachfolgend näher erläutert wird.

Der Kalibrator weist eine interne Batterie 23 oder einen Akkumulator auf, so dass der Kalibrator ohne externe Energieversorgung betrieben werden kann. Darüber hinaus besitzt der Kalibrator Tasten oder andere Eingabemittel 22, über welche der Kalibrator gesteuert werden kann, wobei insbesondere auf diese Weise dem Kalibrator das gewünschte Ladungsniveau sowie die Ladungspolarität der über den Anschluss 10 an das Testobjekt abzugebenden Kalibrierladungspulse vorgegeben werden kann.

Wie in Fig. 1 gezeigt ist, umfasst der Kalibrator eine Anzeige 21 zur Anzeige der über die Eingabemittel 22 eingestellten Werte, insbesondere des eingestellten Ladungsniveaus auf. Der Kalibrator umfasst darüber hinaus eine Fotodiode 20, mit der der Kalibrator durch Erfassung einer mit Netzspannung betriebenen Lichtquelle synchronisiert werden kann.

Im Betrieb erfolgt die Kontrolle des Kalibrators im Wesentlichen über einen optischen Anschluss 12, welcher über ein Glasfaserkabel mit einem Teilentladungsmessgerät oder einem zentralen Steuergerät, verbunden ist. Auf diese Weise kann der Kalibrator ferngesteuert und galvanisch entkoppelt ein- und ausgeschaltet werden bzw. über den optischen Anschluss 12 können verschiedene Parameter wie das Ladungsniveau und die Ladungspolarität sowie die Wiederholrate der über den Anschluss 10 auszugebenden Ladungspulse eingestellt werden. Der Kalibrator weist auch einen optischen Ausgang 11 zur Übermittlung von Messergebnissen an ein daran angeschlossenes Teilentladungsmessgerät bzw. das daran angeschlossene zentrale Steuergerät auf.

Die Außenelektrode 4 ist mit einer internen Referenzkapazität 5, deren Wert $C_{ref}$ bekannt ist, derart gekoppelt, dass die Steukapazität $C_s$ der Außenelektrode 4 mit der internen Referenzkapazität 5 einen kapazitiven Spannungsteiler bildet. Die Außenelektrode 4 bzw. der entsprechende kapazitive Spannungsteiler werden derart von einer einstellbaren Spannungsquelle 6 (beispielsweise eine 90V-Spannungsquelle) angesteuert, dass die aufgrund der Steukapazität $C_s$ in der Außenelektrode 4 gespeicherte Ladung $Q_s$ als Kalibrierladungspuls über den Anschluss 10 ausgegeben werden kann. Zu diesem Zweck wird von der Spannungsquelle 6 an die Außenelektrode ein Spannungssprung $\Delta V$ angelegt, so dass sich für die abgegebene Ladung der folgende Zusammenhang ergibt:

$$Q_S = C_S \cdot \Delta V$$

Der in Fig. 1 dargestellte Kalibrator umfasst eine zentrale Steuereinheit in Form eines Microcontrollers 2, welcher über den optischen Anschluss 12 wie beschrieben ferngesteuert werden kann. Der Microcontroller 2 kann für den Fall, dass die Streukapazität $C_s$ der Außenelektrode 4 bekannt ist, auf einfache Art und Weise die Höhe des Spannungssprungs $\Delta V$ berechnen, welcher erforderlich ist, um an das Testobjekt die gewünschte Ladung bzw. den gewünschten Ladungspuls $Q_s$ als Reaktion auf den Spannungsprung $\Delta V$ abzugeben.

Aufgrund externer Störeinflüsse, welche insbesondere abhängig von der Art und dem Ort des Anschlusses des Kalibrators an das Testobjekt sind, ist jedoch in der Regel die Streukapazität $C_s$ des gesamten Hochspannungsaufbaus, welcher den Kalibrator 1 und das Hochspannungstestobjekt umfasst, nicht bekannt. Demzufolge verfügt gemäß einer bevorzugten Ausführungsform der in Fig. 1 dargestellte Kalibrator über eine Selbstkalibrierfunktion, welche es ermöglicht, den Wert der Streukapazität $C_s$ zuvor zu ermitteln.

Wie bereits erläutert worden ist, bildet die Streukapazität $C_s$ mit der internen Referenzkapazität 5, deren Wert $C_{ref}$ bekannt ist, einen kapazitiven Spannungsteiler. Zur Durchführung der Selbstkalibrierung wird die Hochspannungsquelle 103 des Versuchsaufbaus auf einen Spannungswert gefahren, welcher vom Messgerät 100 genau ermittelt wird. An der internen Referenzkapazität 5 fällt nun eine Spannung $U_{ref}$ ab, welche von der Kapazität $C_s$ abhängig ist. Diese Spannung $U_{ref}$ wird erfasst und über einen Analog/Digital-Wandler 7 dem Microcontroller 2 zugeführt. Der Microcontroller 2 kann daraufhin aus dem bekannten Wert $C_{ref}$ der internen Referenzkapazität 5, dem bekannten Wert der angelegten Testspannung (vom Messgerät 100 über die optische Verbindung 40 übermittelt) und der über den Analog/Digital-Wandler 7 gemessenen Spannung $U_{ref}$, welche an der Referenzkapazität 5 abfällt, den Wert der Streukapazität $C_s$ ermitteln. Nachdem nun die Streukapazität $C_s$ bekannt ist, kann der Microcontroller 2 den zur Realisierung des gewünschten Ladungspulses $Q_s$ erforderlichen Spannungssprung $\Delta V$, welcher an die Außenelektrode 4 anzulegen ist, berechnen.

Es besteht die Möglichkeit einer fortlaufenden Kalibrierung während der Durchführung einer Teilentladungsmessung. Dabei überwacht der Microcontroller 2 permanent den jeweils aktuellen Wert der Streukapazität $C_s$, um den Spannungssprung $\Delta V$ falls erforderlich entsprechend nachstellen zu können.

Aus Fig. 1 ist ersichtlich, dass auf diese Weise der Kalibrator im Prinzip eine Ladungsquelle 3 umfasst, welche als Einzelkomponenten die veränderbare Spannungsquelle 6 sowie die Außenelektrode 4 mit ihrer Streukapazität $C_s$ umfasst. Cs ist dabei nicht durch ein materielles Element repräsentiert, sondern durch die Elektrode 4 und die auf Erdpotential befindliche Umwelt gegeben. Diese Ladungsquelle 3 wird von dem Microcontroller 2 abhängig von dem jeweils aktuellen Wert der Streukapazität $C_s$ über einen Digital/Analog-Wandler 8 derart angesteuert, dass sich am Ausgang 10 des Kalibrators, welcher mit dem Hochspannungs-Testobjekt zu verbinden ist, der gewünschte Ladungspuls $Q_s$ eingeprägt wird.

Die Pulslänge der Kalibrierladungspulse sowie die Pulswiederholrate ist einstellbar und kann beispielsweise 50 ns bzw. 500 Hz betragen. Übliche Wert für die Pulswiederholfate liegen z.B. zwischen 50Hz und mehreren hundert Hz bis ca. 1,2KHz. Das Ladungsniveau der Kalibrierpulse kann beispielsweise von 1 pC bis 1 nC reichen.

Sollte der zuvor beschriebene Selbstkalibriervorgang aufgrund der vorhandenen Betriebsbedingungen wider Erwarten nicht zur Erzeugung von Kalibrierladungspulsen innerhalb eines vordefinierten Toleranzfehlerbereichs führen, können verschiedene Maßnahmen ergriffen werden, um dieses Problem zu beseitigen.

So kann beispielsweise mit einem herkömmlichen Kalibrator am Einsatzort eine Offline-Kalibrierung durchgeführt und anschließend der in Fig. 1 dargestellte Kalibrator anhand des mit dem herkömmlichen Kalibrator bestimmten Kalibrierfaktors eingestellt werden. Der Kalibrator nach Fig. 1 kann nun jedoch während der gesamten Messung im Aufbau verbleiben, ein eventuell vorhandener Einfluss der bei der Offline-Kalibrierung abgeschalteten Hochspannungsquelle 103 wird sofort bemerkt.

Ebenso ist es möglich, den Kalibrator bzw. dessen Außenelektrode 4 innerhalb eines vordefinierten Raums von jeglichen geerdeten oder auf einem signifikanten Spannungspotenzial liegenden Teilen freizuhalten.

Alternativ kann der Kalibrator bzw. dessen Außenelektrode 4 auch in einer definierten Abschirmeinrichtung angeordnet werden, wodurch der Kalibrator und die Außenelektrode gegenüber externen Einflüssen abgeschirmt wird. So kann beispielsweise der Kalibrator in einem geerdeten Behälter oder zwischen zwei Toroiden, von denen sich einer auf Erdpotenzial und der andere auf einem hohen Potenzial befindet, angeordnet werden.

Generell ist es vorteilhaft, wenn für die Außenelektrode 4 eine Struktur verwendet wird, welche gegenüber externen Einflüssen weniger anfällig ist. So können beispielsweise insbesondere zumindest teilweise kugelförmige oder sphärische Außenelektrodenformen verwendet werden, wobei darüber hinaus die zumindest teilweise kugelförmige Elektrode in einem toroid-förmigen Körper angeordnet sein kann, welcher mit dem Gehäuse 1 des Kalibrators verbunden ist.

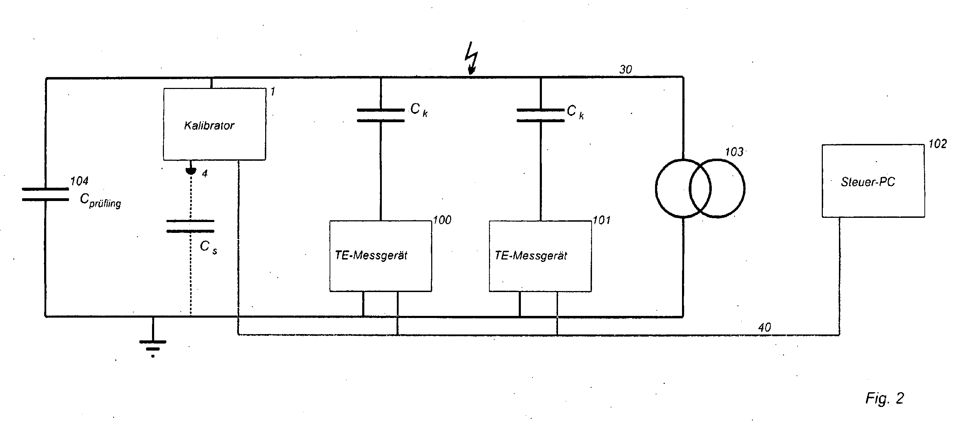

Fig. 2 zeigt eine stark vereinfachte schematische Darstellung des Betriebs des in Fig. 1 dargestellten Kalibrators 1 mit mehreren Hochspannungs-Teilentladungsmessgeräten 100, 101, welche zur Durchführung von Hochspannungs-Teilentladungsmessungen mit einem Testobjekt 104, gemäß dem in Fig. 2 dargestellten Beispiel durch eine Kapazität $C_p$ repräsentiert, über eine Leitung 30 elektrisch verbunden sind, sowie einer Hochspannungsquelle 103. Der Kalibrator 1 ist über den in Fig. 1 dargestellten Anschluss 10 ebenfalls mit dem Testobjekt 104 verbunden. Der Kalibrator besitzt keine direkte Verbindung zum Erdpotenzial. Darüber hinaus ist der Kalibrator 1 mit einem Steuer-PC 102-über die ebenfalls in Fig. 1 dargestellten optischen Anschlüsse 11, 12 mittels eines Glasfasernetzes 40 verbunden.

Über dieses Glasfasernetz 40 können zwischen dem Steuer-PC 102, dem Kalibrator 1 und den Messgeräten 100, 101 Mess- sowie Steuerinformationen galvanisch entkoppelt ausgetauscht werden, wobei darüber hinaus eine einfache und zuverlässige Synchronisierung des Kalibrators 1 und der einzelnen Messgeräte 100, 101 möglich ist.

Das zentrale separate Steuergerät 102 befindet sich außerhalb des Gefahrenbereichs und steuert den Kalibrator 1 sowie die einzelnen Teilentladungsmessgeräte 100, 101 über das Glasfasernetz 40.

**Patentansprüche**

1. Vorrichtung zur Erzeugung eines definierten Ladungspulses zur Durchführung einer Teilentladungsmessung an einer elektrischen Komponente (30),
   mit einem Gehäuse (1), und
   mit einer an dem Gehäuse (1) anzubringenden Außenelektrode (4), eine **gekennzeichnet durch** Steuereinheit (2), welche derart ausgestaltet ist, dass sie abhängig von einer Streukapazität ($C_s$) der Außenelektrode (4) den definierten Ladungspuls ($Q_s$) erzeugt.

2. Vorrichtung nach Anspruch 1,
   **dadurch gekennzeichnet,**
   **dass** die Vorrichtung eine Batterie (23) oder einen Akkumulator zur Energieversorgung der Vorrichtung aufweist.

3. Vorrichtung nach Anspruch 1 oder Anspruch 2,
   **dadurch gekennzeichnet,**
   **dass** die Vorrichtung in Form eines tragbaren Geräts ausgestaltet ist.

4. Vorrichtung nach einem der vorhergehenden Ansprüche,
   **dadurch gekennzeichnet,**
   **dass** die Vorrichtung eine Eingabeeinrichtung (22) zur Einstellung des Ladungsniveaus des Ladungspulses ($Q_s$) aufweist.

5. Vorrichtung nach einem der vorhergehenden Ansprüche,
   **dadurch gekennzeichnet,**
   **dass** die Vorrichtung eine Anzeigeeinrichtung (21) zur Anzeige von Statusinformationen der Vorrichtung aufweist.

6. Vorrichtung nach einem der vorhergehenden Ansprüche,
   **dadurch gekennzeichnet,**
   **dass** die Vorrichtung eine optische Schnittstelle (11, 12) zur Fernsteuerung der Vorrichtung über ein an die optische Schnittstelle (11, 12) anzuschließende Glasfaserleitung aufweist.

7. Vorrichtung nach einem der vorhergehenden Ansprüche,
   **dadurch gekennzeichnet,**
   **dass** die Vorrichtung eine steuerbare Spannungsquelle (6) aufweist, welche derart ausgestaltet und mit der Außenelektrode (4) verschaltet ist, dass durch Anlegen eines Spannungssprungs eine in der Außenelektrode (4) aufgrund deren Streukapazität ($C_s$) gespeicherte Ladung als Ladungspuls ($Q_s$) über einen Anschluss (10) der Vorrichtung ausgegeben werden kann.

8. Vorrichtung nach Anspruch 7,
   **dadurch gekennzeichnet,**
   **dass** die Steuereinheit (2) derart ausgestaltet ist, dass so abhängig von der Streukapazität ($C_s$) der Außenelektrode (4) den zur Erzielung des definierten Ladungspulses ($Q_s$) erforderlichen Spannungssprung ($\Delta V$) ermittelt und die steuerbare Spannungsquelle (6) entsprechend ansteuert.

9. Vorrichtung nach Anspruch 7 oder Anspruch 8,
   **dadurch gekennzeichnet,**
   **dass** die Vorrichtung derart ausgestaltet ist, dass sie die Streukapazität ($C_s$) der Außenelektrode (4) automatisch ermittelt, um davon abhängig durch entsprechende Ansteuerung der Spannungsquelle (6) den definierten Ladungspuls ($Q_s$) zu erzeugen.

10. Vorrichtung nach Anspruch 9,
    **dadurch gekennzeichnet,**
    **dass** die Steuereinheit (2) derart ausgestaltet ist, dass sie zur Bestimmung der Streukapazität ($C_s$) der Außenelektrode (4) durch entsprechende Ansteuerung der Spannungsquelle (6) eine bekannte Spannung an einen kapazitiven Spannungsteiler, welcher die Streukapazität ($C_s$) der Außenelektrode (4) und eine bekannte interne Referenzkapazität (5) umfasst, anlegt, um anschließend durch Auswertung der an der bekannten internen Referenzkapazität (5) abfallenden Spannung ($U_{ref}$) abhängig von der bekannten Spannung und abhängig von dem bekannten Wert ($C_{ref}$) der internen Referenzkapazität (5) die Streukapazität ($C_s$) der Außenelektrode (4) zu ermitteln.

11. Vorrichtung nach Anspruch 9 oder Anspruch 10,
    **dadurch gekennzeichnet,**
    **dass** die Vorrichtung während des Betriebs laufend die Streukapazität ($C_s$) der Außenelektrode (4) ermittelt.

12. Vorrichtung nach einem der vorhergehenden Ansprüche,

**dadurch gekennzeichnet,**
**dass** die Vorrichtung eine Lichterfassungseinrichtung (20) zur Synchronisation des Betriebs der Vorrichtung mit einer externen Lichtquelle umfasst.

13. Vorrichtung nach einem der vorhergehenden Ansprüche,
**dadurch gekennzeichnet,**
**dass** die Außenelektrode (4) lösbar mit dem Gehäuse (1) der Vorrichtung koppelbar ist.

14. Vorrichtung nach einem der vorhergehenden Ansprüche,
**dadurch gekennzeichnet,**
**dass** die Außenelektrode (4) Teil des Gehäuses (1) ist.

15. Vorrichtung nach einem der vorhergehenden Ansprüche,
**dadurch gekennzeichnet,**
**dass** die Außenelektrode (4) zumindest eine teilweise kugelförmige oder sphärische Oberfläche aufweist.

16. Vorrichtung nach Anspruch 15,
**dadurch gekennzeichnet,**
**dass** die Außenelektrode (4) eine vollständig kugelförmige oder halbkugelförmige Oberfläche aufweist.

17. Vorrichtung nach einem der vorhergehenden Ansprüche,
**dadurch gekennzeichnet,**
**dass** die Außenelektrode (4) eine toroid-förmige Oberfläche aufweist.

18. Vorrichtung nach Anspruch 16 oder Anspruch 17,
**dadurch gekennzeichnet,**
**dass** die Außenelektrode (4) eine zumindest teilweise kugelförmige Elektrodenoberfläche aufweist, welche in einem toroid-förmigen Elektrodenkörper angeordnet ist, wobei der toroid-förmige Elektrodenkörper mit dem Gehäuse (1) zu koppeln ist.

19. Vorrichtung nach einem der vorhergehenden Ansprüche,
**dadurch gekennzeichnet,**
**dass** die Vorrichtung eine Abschirmeinrichtung zur Abschirmung der Außenelektrode (4) gegenüber externen Störeinflüssen aufweist, wobei die Außenelektrode (4) innerhalb der Abschirmeinrichtung anzuordnen ist.

20. Vorrichtung nach Anspruch 19,
**dadurch gekennzeichnet,**
**dass** die Abschirmeinrichtung einen geerdeten Behälter umfasst, in dem die Außenelektrode (4) anzuordnen ist.

21. Vorrichtung nach Anspruch 19,
**dadurch gekennzeichnet,**
**dass** die Abschirmeinrichtung einen ersten toroidförmigen Körper und einen zweiten toroid-förmigen Körper umfasst, wobei der erste toroid-förmige Körper auf Erdpotenzial und der zweite toroid-förmige Körper auf einem höheren Spannungspotenzial liegt und die Außenelektrode (4) innerhalb der beiden toroid-förmigen Körper anzuordnen ist.

22. Messsystem zur Durchführung einer Teilentladungsmessung an einer elektrischen Komponente, mit mindestens einem Teilentladungsmessgerät (100, 101) zur Durchführung einer Teilentladungsmessung an der elektrischen Komponente (30), und mit einer Vorrichtung nach einem der vorhergehenden Ansprüche zur Erzeugung eines definierten Kalibrierladungspulses zur Kalibrierung der Durchführung der Teilentladungsmessung durch das mindestens eine Teilentladungsmessgerät (100, 101).

23. Messsystem nach Anspruch 22,
**dadurch gekennzeichnet,**
**dass** das Messsystem zur Durchführung von Hochspannungs-Teilentladungsmessungen ausgestaltet ist.

24. Messsystem nach Anspruch 22 oder Anspruch 23,
**dadurch gekennzeichnet,**
**dass** das Messsystem zur Durchführung von Teilentladungsmessungen an einem Kabel oder einem Transformator als die elektrische Komponente ausgestaltet ist.

25. Messsystem nach einem der Ansprüche 22-24,
**dadurch gekennzeichnet,**
**dass** die Vorrichtung (1) zur Erzeugung des definierten Kalibrierladungspulses und das mindestens eine Teilentladungsmessgerät (100, 101) über eine optische Glasfaserverbindung (4) miteinander verbunden sind.

26. Verfahren zur Erzeugung eines definierten Ladungspulses zur Durchführung einer Teilentladungsmessung an einer elektrischen Komponente (30), umfassend den Schritt Erzeugen des definierten Ladungspulses ($Q_s$) abhängig von einer Streukapazität ($Q_s$) einer Außenelektrode (4) einer entsprechenden Vorrichtung (1),
wobei der definierte Ladungspuls ($Q_s$) abhängig von einer in Folge eines Spannungssprungs ($\Delta V$) in der Außenelektrode (4) gespeicherten Ladung erzeugt wird.

27. Verfahren nach Anspruch 26,
**dadurch gekennzeichnet,**
**dass** der definierte Ladungspuls ($Q_s$) unter Verwendung einer Vorrichtung nach einem der Ansprüche 1-21 erzeugt wird.

**Claims**

1. Device for generating a defined charge pulse for performing a partial discharge measurement at an electrical component (30), comprising
a housing (1), and
an external electrode (4) to be mounted at the housing (1), **characterized by**
a control unit (2) adapted to generate the defined charge pulse ($Q_s$) in dependence on a stray capacitance ($C_s$) of the external electrode (4).

2. Device according to claim 1,

   **characterized in that** the device comprises a battery (23) or an accumulator for supplying the device with energy.

3. Device according to claim 1 or claim 2,
   **characterized in that**
   the device is configured in the form of a portable equipment.

4. Device according to any one of the preceding claims,
   **characterized in that**
   the device includes an input device (22) for setting the charge level of the charge pulse ($Q_s$).

5. Device according to any one of the preceding claims,

   **characterized in that**
   the device includes a display device (21) for displaying status information of the device.

6. Device according to any one of the preceding claims,
   **characterized in that** the device includes an optical interface (11, 12) for remote controlling the device via a fibre optic cable to be connected to the optical interface (11, 12).

7. Device according to any one of the preceding claims,
   **characterized in that**
   the device includes a controllable voltage source (6) configured and connected to the external electrode (4) such that by supplying a voltage jump a charge stored in the outer electrode (4) due to its stray capacitance ($C_s$) can be output as a charge pulse ($Q_s$) via a terminal (10) of the device.

8. Device according to claim 7,
   **characterized in that**
   the control unit (2) is configured such that it determines the voltage jump ($\Delta V$) required for achieving the defined charge pulse ($Q_s$) depending on the stray capacitance ($C_s$) of the external electrode (4), and controls the controllable voltage source (6) accordingly.

9. Device according to claim 7 or claim 8,
   **characterized in that**
   the device is configured such that it determines the stray capacitance ($C_s$) of the external electrode (4) automatically to generate in response thereto the defined charge pulse ($Q_s$) by correspondingly controlling the voltage source (6).

10. Device according to claim 9,
    **characterized in that**
    the control unit (2) is configured such that, for determining the stray capacitance ($C_s$) of the external electrode (4) by correspondingly controlling the voltage source (6), it supplies a known voltage to a capacitive voltage divider comprising the stray capacitance ($C_s$) of the external electrode (4) and a known internal reference capacitance (5) to determine subsequently the stray capacitance ($C_s$) of the external electrode (4) by evaluating the voltage ($U_{ref}$) being dropped at the known internal reference capacitance (5) depending on the known voltage and depending on the known value ($C_{ref}$) of the internal reference capacitance (5).

11. Device according to claim 9 or claim 10,
    **characterized in that**
    the device determines continuously in operation the stray capacitance ($C_s$) of the outer electrode (4).

12. Device according to any one of the preceding claims,
    **characterized in that**

    the device comprises a light detecting device (20) for synchronizing the operation of the device with an external light source.

13. Device according to any one of the preceding claims,
    **characterized in that**

    the external electrode (4) is detachably coupleable to the housing (1) of the device.

14. Device according to any one of the preceding claims,
    **characterized in that**

    the external electrode (4) is part of the housing (1).

15. Device according to any of the preceding claims,
    **characterized in that**
    the external electrode (4) comprises at least a partially spherical surface.

16. Device according to claim 15,
    **characterized in that**
    the external electrode (4) includes a completely spherical or hemispherical surface.

17. Device according to any one of the preceding claims, **characterized in that** the external electrode (4) includes a toroid-shaped surface.

18. Device according to claim 16 or 17, **characterized in that** the external electrode (4) includes an at least partially spherical electrode surface arranged in a toroid-shaped electrode body, wherein the toroid-shaped electrode body is to be coupled to the housing (1).

19. Device according to any one of the preceding claims, **characterized in that** the device includes a shielding device for shielding the external electrode (4) against external perturbations, wherein the external electrode (4) is to be arranged inside the shielding device.

20. Device according to claim 19, **characterized in that** the shielding device comprises a grounded container in which the outer electrode (4) is to be arranged.

21. Device according to claim 19, **characterized in that** the shielding device comprises a first toroid-shaped body and a second toroid-shaped body, wherein the first toroid-shaped body is at ground potential and the second toroid-shaped body is at a higher voltage potential, and wherein the external electrode (4) is to be arranged inside the two toroid-shaped bodies.

22. Measurement system for conducting a partial discharge measurement at an electrical component, including at least one partial discharge measurement device (100, 101) for conducting a partial discharge measurement at the electrical component (30), and a device according to any one of the preceding claims for generating a defined calibrating charge pulse for calibrating the conducting of the partial discharge measurement by the at least one partial discharge measurement device (100, 101).

23. Measurement system according to claim 22, **characterized in that** the measurement system is configured to conduct high voltage partial discharge measurements.

24. Measurement system according to claim 22 or claim 23, **characterized in that** the measurement system is configured to conduct partial discharge measurements at a cable or a transformer as the electrical component.

25. Measurement system according to any of claims 22-24, **characterized in that** the device (1) for generating the defined calibrating charge pulse and the at least one partial discharge measurement device (100, 101) are coupled via a fibre optic link (4).

26. Method for generating a defined charge pulse for conducting a partial discharge measurement at an electrical component (30), comprising the step of generating the defined charge pulse ($Q_s$) in dependence on a stray capacitance ($Q_s$) of an external electrode (4) of a corresponding device (1), wherein the defined charge pulse ($Q_s$) is generated in dependence on a charge stored in the external electrode (4) due to a voltage jump ($\Delta V$).

27. Method according to claim 26, **characterized in that** the defined charge pulse ($Q_s$) is generated using a device according to any one of claims 1-21.

**Revendications**

1. Dispositif de production d'une impulsion de charge définie pour l'exécution d'une mesure de décharge partielle sur un composant électrique (30), comprenant un boîtier (1), et comprenant une électrode extérieure (4) à installer sur le boîtier (1), **caractérisé par** une unité de commande (2) conçue de telle sorte qu'elle produit l'impulsion de charge ($Q_s$) définie en fonction d'une capacité parasite ($C_s$) de l'électrode extérieure (4).

2. Dispositif selon la revendication 1, **caractérisé en ce** **que** le dispositif comprend une batterie (23) ou un accumulateur destiné à alimenter le dispositif en énergie.

3. Dispositif selon la revendication 1 ou la revendication 2, **caractérisé en ce** **que** le dispositif est conçu sous forme d'un appareil portatif.

4. Dispositif selon l'une quelconque des revendications précédentes, **caractérisé en ce** **que** le dispositif comprend un appareil de saisie (22) destiné à régler le niveau de charge de l'impulsion de charge ($Q_s$).

5. Dispositif selon l'une quelconque des revendications précédentes,
**caractérisé en ce**
**que** le dispositif comprend un appareil d'affichage (21) destiné à afficher des information de statut du dispositif.

6. Dispositif selon l'une quelconque des revendications précédentes,
**caractérisé en ce**
**que** le dispositif comprend une interface optique (11, 12) destinée à commander à distance le dispositif par l'intermédiaire d'une conduite en fibre de verre se raccordant à l'interface optique (11, 12).

7. Dispositif selon l'une quelconque des revendications précédentes,

**caractérisé en ce**
**que** le dispositif comprend une source de tension (6) pouvant être commandée, laquelle est conçue et branchée avec l'électrode extérieure (4) de telle sorte que l'application d'un saut de tension permet d'éditer une charge emmagasinée dans l'électrode extérieure (4) en raison de la capacité parasite ($C_s$) de celle-ci en tant qu'impulsion de charge ($Q_s$) par l'intermédiaire d'un raccordement (10) du dispositif.

8. Dispositif selon la revendication 7,
**caractérisé en ce**
**que** l'unité de commande (2) est conçue de telle sorte qu'elle détermine en fonction de la capacité parasite ($C_s$) de l'électrode extérieure (4) le saut de tension (V) nécessaire pour obtenir l'impulsion de charge ($Q_s$) définie et commande d'une manière appropriée la source de tension (6) pouvant être commandée.

9. Dispositif selon la revendication 7 ou la revendication 8,
**caractérisé en ce**
**que** le dispositif est conçu de telle sorte qu'il détermine automatiquement la capacité parasite ($C_s$) de l'électrode extérieure (4), afin de produire indépendamment de cela, du fait de la commande correspondante de la source de tension (6), l'impulsion de charge ($Q_s$) définie.

10. Dispositif selon la revendication 9,
**caractérisé en ce**
**que** l'unité de commande (2) est conçue de telle sorte que pour déterminer la capacité parasite ($C_s$) de l'électrode extérieure (4) par une commande correspondante de la source de tension (6), elle applique une tension connue sur un diviseur de tension capacitif comportant la capacité parasite ($C_s$) de l'électrode extérieure (4) et une capacité de référence interne (5) connue, afin de déterminer ensuite, par l'analyse de la tension ($U_{ref}$) chutant sur la capacité de référence interne (5) connue en fonction de la tension connue et en fonction de la valeur ($C_{ref}$) connue de la capacité de référence interne (5) la capacité parasite ($C_s$) de l'électrode extérieure (4).

11. Dispositif selon la revendication 9 ou la revendication 10,
**caractérisé en ce**
**que** le dispositif détermine en continu la capacité parasite ($C_s$) de l'électrode extérieure (4) pendant le fonctionnement.

12. Dispositif selon l'une quelconque des revendications précédentes,
**caractérisé en ce**
**que** le dispositif comporte un appareil de détection de lumière (20) destiné à synchroniser le fonctionnement du dispositif avec une source de lumière externe.

13. Dispositif selon l'une quelconque des revendications précédentes,
**caractérisé en ce**
**que** l'électrode extérieure (4) peut être couplée de manière amovible au boîtier (1) du dispositif.

14. Dispositif selon l'une quelconque des revendications précédentes,
**caractérisé en ce**
**que** l'électrode extérieure (4) fait partie du boîtier (1).

15. Dispositif selon l'une quelconque des revendications précédentes,
**caractérisé en ce**
**que** l'électrode extérieure (4) comprend au moins une surface en partie sphérique.

16. Dispositif selon la revendication 15,
**caractérisé en ce**
**que** l'électrode extérieure (4) comprend une surface entièrement sphérique ou semi-sphérique.

17. Dispositif selon l'une quelconque des revendications précédentes,
**caractérisé en ce**
**que** l'électrode extérieure (4) comprend une surface toroïdale.

18. Dispositif selon la revendication 16 ou la revendication 17,
**caractérisé en ce**
**que** l'électrode extérieure (4) comprend une surface d'électrode au moins en partie sphérique disposée dans un corps d'électrode toroïdal, le corps d'électrode toroïdal devant être couplé au boîtier (1).

19. Dispositif selon l'une quelconque des revendications précédentes,

**caractérisé en ce**
**que** le dispositif comprend un appareil de protection destiné à protéger l'électrode extérieure (4) par rapport aux perturbations externes, l'électrode extérieure (4) devant être disposée à l'intérieur de l'appareil de protection.

20. Dispositif selon la revendication 19,
**caractérisé en ce**
**que** l'appareil de protection comporte un récipient mis à la terre dans lequel doit être disposée l'électrode extérieure (4).

21. Dispositif selon la revendication 19,
**caractérisé en ce**
**que** l'appareil de protection comporte un premier corps toroïdal et un second corps toroïdal, le premier corps toroïdal étant au potentiel terrestre et le second corps toroïdal étant à un potentiel de tension plus élevé et l'électrode extérieure (4) devant être disposée à l'intérieur des deux corps toroïdaux.

22. Système de mesure destiné à réaliser une mesure de décharge partielle sur un composant électrique, comprenant au moins un appareil de mesure de décharge partielle (100, 101) destiné à réaliser une mesure de décharge partielle sur le composant électrique (30), et
comprenant un dispositif selon l'une quelconque des revendications précédentes destiné à produire une impulsion de charge de calibrage destinée à calibrer la réalisation de la mesure de décharge partielle par le ou les appareils de mesure de décharge partielle (100, 101).

23. Système de mesure selon la revendication 22,
**caractérisé en ce**
**que** le système de mesure est conçu pour réaliser des mesures de décharge partielle à haute tension.

24. Système de mesure selon la revendication 22 ou la revendication 23,
**caractérisé en ce que** le système de mesure destiné à réaliser des mesures de décharge partielle sur un câble ou un transformateur est conçu comme le composant électrique.

25. Système de mesure selon l'une quelconque des revendications 22 à 24,
**caractérisé en ce**
**que** le dispositif (1) destiné à produire l'impulsion de charge de calibrage définie et le ou les appareils de mesure de décharge partielle (100, 101) sont reliés les uns aux autres par une liaison à fibre de verre optique (4).

26. Procédé de production d'une impulsion de charge définie destinée à réaliser une mesure de décharge partielle sur un composant électrique (30), comportant l'étape consistant à produire l'impulsion de charge définie ($Q_S$) en fonction d'une capacité parasite ($Q_S$) d'une électrode extérieure (4) d'un dispositif (1) correspondant,
l'impulsion de charge définie ($Q_S$) étant produite en fonction d'une charge emmagasinée à la suite d'un saut de tension ( V) dans l'électrode extérieure (4).

27. Procédé selon la revendication 26,
**caractérisé en ce**
**que** l'impulsion de charge définie ($Q_S$) est produite en utilisant un dispositif selon l'une quelconque des revendications 1 à 21.

Fig. 1

Fig. 2

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 3912654 A1
- US 7119597 B1
- US 20050128655 A1